(19) Europäisches Patentamt
European Patent Office
Office européen des brevets

(11) **EP 4 567 532 A1**

(12) **EUROPEAN PATENT APPLICATION**

(43) Date of publication:
**11.06.2025 Bulletin 2025/24**

(21) Application number: **24213180.3**

(22) Date of filing: **15.11.2024**

(51) International Patent Classification (IPC):
***G05B 13/04*** (2006.01)       ***F24F 11/46*** (2018.01)
***G05B 17/02*** (2006.01)

(52) Cooperative Patent Classification (CPC):
**G05B 13/048; F24F 11/46; G05B 17/02**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.11.2023 US 202363603476 P
04.11.2024 US 202418936683**

(71) Applicant: **Vertiv Corporation
Westerville, OH 43082 (US)**

(72) Inventors:
• **Takacs, Balint
  Westerville, 43082 (US)**
• **Lionello, Michele
  Westerville, 43082 (US)**

(74) Representative: **Cousens, Nico et al
Kilburn & Strode LLP
Lacon London
84 Theobalds Road
London WC1X 8NL (GB)**

(54) **NEURAL NETWORK DRIVEN MANAGEMENT OPTIMIZATION FOR SYSTEM OF CHILLER DEVICES**

(57)     A system and method for optimizing management of a system of multiple chiller devices for circulating a chilled medium within an indoor environment determines a current state of the environment (e.g., ambient temperature, temperature of the medium entering and leaving the environment, inlet flow rate of chilled medium, target cooling load) and a current configuration of the chiller system, e.g., flow and outlet temperature setpoints of each active device and total energy consumption of the chiller system. Based on this information the chiller system controller solves (either offline or online) for an optimal chiller system configuration (and steps for achieving this configuration by adjusting chiller device flow and outlet temperature setpoints) for providing the required cooling load to the indoor environment while minimizing total energy consumption across the chiller system. If an optimal solution is found, the controller monitors its implementation.

**FIG. 1A**

**Description**

CROSS-REFERENCE TO RELATED APPLICATIONS

The present application claims priority to U.S. Provisional Patent Application Number 63/603,476, filed November 28, 2023.

TECHNICAL FIELD

The present disclosure is directed generally to the field of chiller systems for data centers and similar controlled-temperature environments, and more particularly, to control systems for automated management of said chiller systems.

BACKGROUND

Chiller devices, or chillers, are cooling delivery devices capable of circulating a cooling medium (e.g., water or some other working medium or fluid) through a datacenter, plant, or like environment (e.g., a controlled indoor location or space to be cooled) to regulate, e.g., temperature, humidity, and/or airflow within the environment. Broadly speaking, the chiller will cool the medium and supply the cooled medium to the environment, where heat is transferred to the medium such that the medium exits the environment and is circulated back to the chiller at a higher temperature. The medium is once again cooled and recirculated to the environment in a continuous cycle, such that the environment can be maintained at a desired temperature. Accordingly, the goal of a chiller device (or system of multiple chiller devices) is to provide for the warmer medium leaving the environment to be chilled to a sufficiently low temperature and provided back to the environment at a sufficient flow rate to ensure the desired temperature of the environment is maintained.

The delta or difference in temperature between the (cooler) medium entering the environment and (warmer) medium exiting the environment defines the requested cooling capacity of a chiller or chiller system (e.g., to maintain a desired or target temperature). If, for example, cooling requirements increase (e.g., ambient temperatures at or near the environment increase relative to the target temperature) the chiller or chiller system may increase its cooling capacity, e.g., ramping up compressors or activating previously inactive compressors of a closed multi-chiller system. Given such a closed multi-chiller system, the challenge then is to provide or maintain a required cooling capacity in the most efficient way, e.g., at a minimal energy consumption rate.

SUMMARY

In a first aspect, a system of chiller devices configured to maintain an environment or plant within a target temperature range on an uninterrupted basis while dynamically minimizing total energy consumption is disclosed. In embodiments, the chiller devices collectively circulate a coolant fluid through a supply conduit to the plant and return the coolant fluid to the chiller devices via a return conduit. Each chiller device may be active or inactive (e.g., on or off) and has a range of possible outlet temperatures and flow rates (e.g., for coolant fluid circulating to the plant). A supervisory control device of the chiller system monitors an environmental state of the plant or environment, which includes a required cooling load based on the target temperature range. The control device assesses the current configuration of the chiller system, e.g., the active or inactive status and the current setpoints of each active chiller device. Further, the control device assesses the total energy consumption based on the current configuration. Based on the current state, the control device attempts to determine one or more optimizing solutions, or sequences of actions whereby the required cooling load can be maintained uninterrupted while reducing the total energy consumption.

In some embodiments, an optimizing solution includes adjusting an outlet temperature setpoint and/or flow rate setpoint of at least one active chiller device.

In some embodiments, an optimizing solution may further include activating an inactive chiller device or deactivating an active chiller device (e.g., changing the total number of active chiller devices).

In some embodiments, the control device changes a flow rate setpoint of an active chiller device by ramping the current flow rate setpoint to the target flow rate setpoint associated with an optimizing solution.

In some embodiments, the control device changes an outlet temperature setpoint of an active chiller device by ramping the current outlet temperature setpoint to the target outlet temperature setpoint associated with an optimizing solution.

In some embodiments, the control device models possible configurations of the chiller system, e.g., possible sets of an active subset of chiller devices and outlet temperature/flow rate setpoints for each active chiller device. Further, the chiller system includes a memory or like data storage to which the modeled possible chiller system configurations may be saved or stored.

In some embodiments, the chiller system determines an optimizing solution by selecting a stored possible chiller system configuration from memory, e.g., if the possible configuration maintains the required cooling load associated with the current state.

In some embodiments, the control device models possible chiller system configurations via neural networks or like regression models.

In some embodiments, the control device executes an action of an optimizing solution, wherein the optimizing solution comprises a set or sequence of such actions (e.g., adjusting a setpoint, activating a chiller device, deactivating a chiller device). The control device collects data from throughout the chiller system (e.g., setpoints, environmental conditions) to confirm steady state operations of the chiller system for at least a threshold duration. The control device then (e.g., after steady state operation is established) assesses a subsequent energy consumption level of the chiller system based on the executed action. If, for example, the subsequent energy consumption level is less than the current/prior energy consumption level by at least a threshold amount, the control device proceeds to the next action of the sequence.

In some embodiments, the current state of the environment includes an ambient air temperature proximate to the plant, an inlet temperature of coolant fluid entering the plant via the supply conduit, an outlet temperature of coolant fluid leaving the plant via the return conduit, and a flow rate of coolant fluid entering the plant.

In a further aspect, a method for dynamic optimization management of a chiller system, via which an environment or plant is maintained within a target temperature range, is disclosed. In embodiments, the method includes providing a chiller system of one or more chiller devices for circulating a coolant fluid through the plant, each chiller device either inactive or active and each active chiller device having a range of possible outlet temperature setpoints and a range of possible flow rate setpoints. The method includes determining, via a supervisory control device of the chiller system, a current state of the plant (including a required cooling load based on the target temperature range). The method includes determining a current configuration of the chiller system, e.g., the active or inactive status and the outlet temperature and flow rate setpoints of each chiller device. The method includes determining a current energy consumption level of the chiller system, based on the current configuration and state within the plant. The method includes determining one or more optimizing solutions for maintaining the required cooling load while reducing overall energy consumption, where each optimizing solution comprises a set or sequence of actions.

In some embodiments, an optimizing solution includes adjusting an outlet temperature or flow rate setpoint for at least one active chiller device.

In some embodiments, an optimizing solution includes activation of an inactive chiller device or deactivation of an active chiller device, e.g., changing the number of active chiller devices.

In some embodiments, the method includes adjusting a flow rate setpoint of an active chiller device by ramping the current flow rate setpoint to a target flow rate setpoint (e.g., associated with an optimizing solution).

In some embodiments, the method includes adjusting an outlet temperature setpoint of an active chiller device by ramping the current outlet temperature setpoint to a target outlet temperature setpoint (e.g., associated with an optimizing solution).

In some embodiments, the method includes mathematically modeling a set of possible configurations of the chiller system. Further, the method includes storing the set of modeled possible configurations to memory or other data storage of the supervisory control device.

In some embodiments, the method includes selecting as an optimizing solution a pre-modeled and stored configuration of the chiller system, e.g., if the modeled configuration achieves the required cooling load while reducing overall energy consumption.

In some embodiments, the method includes modeling the possible chiller system configurations via neural network or similarly appropriate regression models.

In some embodiments, the method includes executing a first action of the optimizing solution action sequence, and verifying through data collection that steady state operations of the chiller system have resumed for at least a threshold duration. The method includes determining a subsequent energy consumption level of the chiller system based on the executed action. The method includes determining a delta or difference between subsequent and previous energy consumption levels. The method includes, when the delta meets or exceeds a threshold level, executing the next action of the optimizing solution.

In some embodiments, the current state of the environment includes an ambient air temperature proximate to the plant, an inlet temperature of coolant fluid entering the plant via the supply conduit, an outlet temperature of coolant fluid leaving the plant via the return conduit, and a flow rate of coolant fluid entering the plant.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

BRIEF DESCRIPTION OF THE FIGURES

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:

FIG. 1A is a block diagram of a multi-device chiller system ("coolant delivery system") according to example embodiments of the inventive concepts disclosed herein;

FIG. 1B is a block diagram of a single-device embodiment of the chiller system of FIG. 1A;

FIG. 2 is a block diagram of the chiller system of FIG. 1A including a supervisory central control device;

FIG. 3 is a diagrammatic illustration of operations mathematically modeling the chiller system of FIG. 2;

FIG. 4 is a diagrammatic illustration of solution determination and evaluation operations for a reinforcement learning (RL, R/L) agent configured for optimizing the chiller system of FIG. 2;

FIG. 5A is a diagrammatic illustration of data collection and modeling operations of the chiller system of FIG. 2;

FIG. 5B is a diagrammatic illustration of initialization operations of the chiller system of FIG. 2;

FIG. 6A is a diagrammatic illustration of online optimization operations of the chiller system of FIG. 2;

FIG. 6B is a diagrammatic illustration of solution evaluation operations of the chiller system of FIG. 2;

FIG. 7 is a diagrammatic illustration of offline optimization operations of the chiller system of FIG. 2;

and FIGS. 8A and 8B are a process flow diagrams illustrating a method for optimizing management of a chiller system according to example embodiments of the inventive concepts disclosed herein.

DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to methods and systems for optimizing management of a closed system of multiple chiller devices to ensure that the chiller system is delivering a required cooling capacity with optimal efficiency. For example, multi-chiller management optimization involves solving the problem of load partitioning, and the activation and deactivation of individual chiller devices of the system, to provide the required cooling capacity at a minimum energy cost, while cooling load and ambient air conditions are subject to change.

The cooling load of a chiller system, for example, is proportional to the flow rate of the medium into the environment to be cooled, as well as the temperature difference between a supplied and returning medium. Accordingly, a required cooling load may be achieved by various different combinations of flow rate and supplied medium temperature among the chiller system, where different combinations are associated with different energy consumption levels or rates.

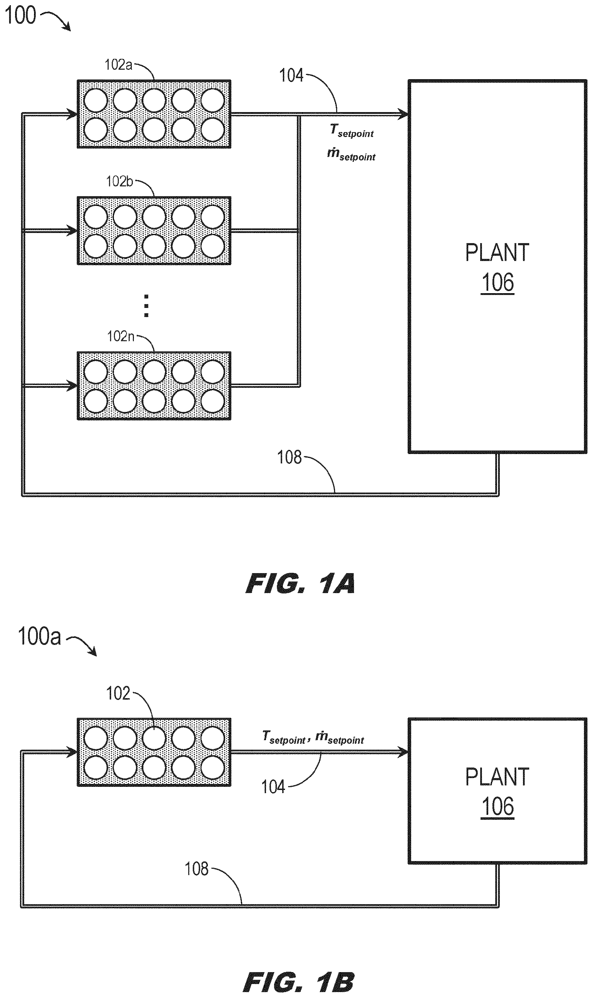

Referring to FIGS. 1A and 1B, a chiller system 100 (e.g., coolant delivery system) of n chiller devices 102a, 102b ... 102n (e.g., coolant delivery devices) is shown. For instance, $n$ may be an integer not less than two, although the inventive concepts disclosed herein may likewise be applied to a chiller system 100a including a single chiller device 102 (e.g., $n$ = 1). In embodiments, any references to the chiller system 100 of chiller devices 102a-102n may also be taken as referring to the chiller system 100a of chiller device 102, where applicable. With respect to the chiller system 100a shown by FIG. 1B, it may be noted that as the chiller system 100a includes only one chiller device 102, possible chiller system configuration may be limited to the flow rate setpoint and outlet temperature setpoint of the chiller device 102, While each flow rate and outlet temperature setpoint may each be associated with a range of possible values, only one flow rate and outlet temperature setpoint may be possible for the single chiller device 102 at any particular time. Similarly, the activation of inactive chiller devices, and deactivation of active chiller devices, may not apply to the chiller system 100a as the single chiller device 102 remains active.

In embodiments, referring in particular to the chiller system 100 shown by FIG. 1A, the chiller devices 102a-102n may be connected in parallel such that a single conduit 104 provides a coolant fluid (e.g., coolant medium, working fluid) to an environment or plant 106 to be maintained within a target temperature range, or below a threshold temperature. For example, the chiller system 100 may provide the coolant fluid to the plant 106 via the conduit 104 at a target (desired) inlet temperature $T_{inlet}$ and a target flow rate $\dot{m}$. For example, the target inlet temperature $T_{inlet}$ or target flow rate $\dot{m}$ may be determined based on the required temperature range or temperature threshold within the plant 106. In embodiments, the chiller system 100 (e.g., where $n$ > 1) may achieve target inlet temperature $T_{inlet}$ or target flow rate $\dot{m}$ via a mixture of warmer and cooler fluids in a specific ratio. With respect to a single-chiller system 100a (e.g., wherein $n$ = 1), a specific inlet temperature may provide no room for optimization, but an acceptable range for target inlet temperature $T_{inlet}$, e.g., 18° - 22° C, may provide opportunities for optimizing energy consumption within the acceptable inlet temperature range.

In embodiments, coolant fluid may be returned to the chiller system 100 or 100a via the return conduit 108, having absorbed heat from within the plant 106. For example, returning fluid may leave the plant 106 at a particular return temperature and may be circulated via the return conduit 108 back to the chiller system 100 or 100a for recooling and dispersal of the absorbed heat.

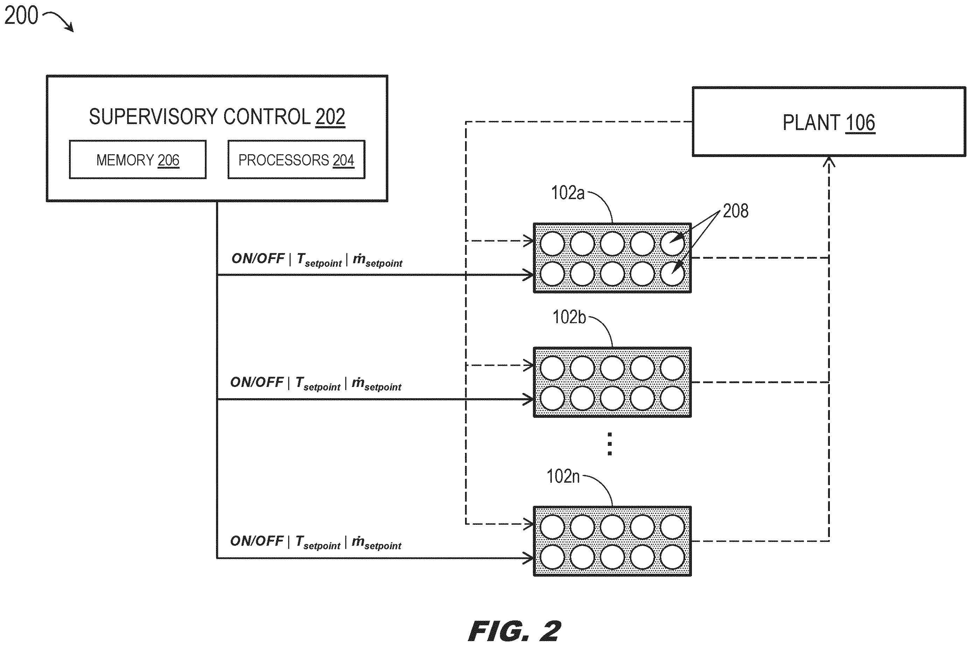

Referring to FIG. 2, the chiller system 200 may be implemented and may function similarly to the chiller system 100 of FIG. 1A, except that the chiller system 100 may include a supervisory control device 202 comprising processors 204 and memory 206 (or other appropriate data storage).

In embodiments, the supervisory control device 202 may maintain the supply temperature $T_{inlet}$ and flow rate $\dot{m}$ through management of each individual chiller device 102a-102n. For example, each of the $n$ chiller devices 102a-102n may have an active/inactive setting (e.g., determining whether the compressors 208 of that chiller device are active or inactive; individual chiller devices with multiple compressor units may locally control activation, ramping, deactivation, etc. of component compressor units on an individual or group basis) as well as an outlet temperature setpoint temperature $T_{setpoint}$ and flow rate $\dot{m}_{setpoint}$ regulating the temperature and flow rate of the coolant fluid from that particular chiller device (i.e., the cooling capacity of that chiller device). Accordingly, for any required cooling load to be achieved by the chiller system 200 of $n$ chiller devices 102a-102n, this load may be provided by a higher number of active chiller devices (e.g., wherein each active chiller device operates at a lower cooling capacity), or a lower number of active chiller devices (e.g., wherein each active chiller device operates at a higher cooling capacity). While any number of possible configurations of the chiller devices 102a-102n may achieve the required cooling load, the question of which of these configurations or combinations is the most energy efficient, i.e., consumes the least energy overall, is not a straightforward one.

In light of the above, embodiments of the inventive concepts disclosed herein are directed to a chiller system architecture and control system thereof configured to determine, given a required cooling load, the optimal chiller system configuration for achieving and maintaining the required cooling load on a continual basis while minimizing energy consumption. For example, given a system 200 of n chiller devices 102a-102n, any possible chiller system configuration (including the current chiller system configuration and the optimal chiller system configuration) will define which chiller devices are active and which are inactive, as well as a specific outlet temperature setpoint $T_{setpoint}$ and flow rate setpoint $\dot{m}_{setpoint}$ for each active chiller device. Further, achieving a determined optimal chiller system configuration that differs from the current optimal chiller system configuration may involve a series or sequence of actions, i.e., an optimizing solution, wherein the operation of the chiller system 200 is converted from the current configuration to the optimal configuration, all while maintaining uninterrupted delivery of the required cooling load. Further still, the supervisory control device 202 may evaluate whether or not specific actions suggested by the optimizing solution should be implemented.

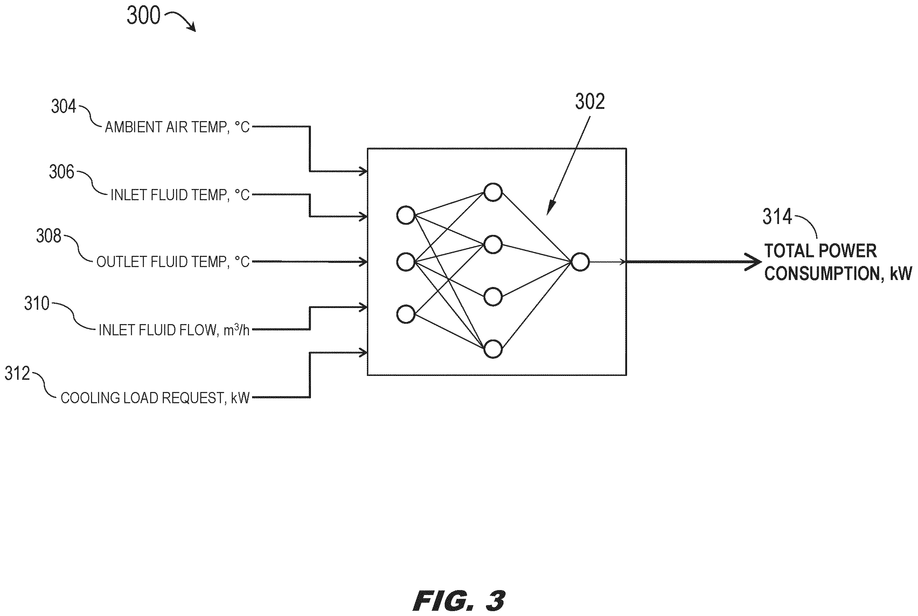

In embodiments, referring now to FIG. 3, in order to determine whether a proposed modification of chiller system control policy, i.e., an optimizing solution, can reduce energy consumption while maintaining uninterrupted cooling capacity, the chiller system 200 (see FIG. 2) may be mathematically modeled (300; via, e.g., white-box, black-box, grey-box modeling). For example, black-box modeling (e.g., exclusively based on data rather than physical rules) may incorporate regression-based neural networks 302 or other like regression methods. Based on neural network models 302 trained to predict electrical consumption of a single chiller device 102a-102n (see FIG. 2) of a given chiller system 200, as well as neural network modelings of various configurations of the given chiller system under a broad variety of possible working conditions (e.g., variations in cooling capacity, flow rate, inlet temperature among the component chillers), a neural network-based chiller system model 300 may be trained to take as input environmental conditions representing a possible state of the environment to be cooled by the chiller system:

- an ambient air temperature 304 of the environment (e.g., °C);

- an inlet fluid temperature 306 of chilled coolant fluid entering the plans (106, FIG. 1);

- an outlet fluid temperature 308 of coolant fluid returning to the chiller system 100 from the plant 106;

- a flow rate 310 of chilled coolant fluid entering the plant 106 (e.g., $m^3/hr$); and

- a requested or required cooling load 312 (e.g., kW).

In embodiments, given this set of environmental conditions 304-312 as inputs, the chiller system model 300 may predict the total electrical power consumption 314 (e.g., in KW) for a given chiller system configuration (e.g., for achieving and/or maintaining the required cooling load 312 from a given ambient air temperature 304, inlet fluid temperature 306, outlet fluid temperature 308, and flow rate 310). Further, based on the precise depth and/or architecture of the chiller system model 300, a prediction of total power consumption 314 may be made with a desired error bound.

In some embodiments, and as described in greater detail below, computationally expensive modeling may be performed offline, simplifying later optimization operations online (trading lost flexibility of operations, e.g., the capacity for chiller system fine tuning, for reduced computational demand). For example, in an offline phase, a set of possible chiller system configurations may be modeled and stored in memory 206 of the supervisory control device 202 (see, e.g., FIG. 2). Accordingly, the processors 204 of the supervisory control device 202 may solve the optimization problem in the online phase by selecting an optimal chiller system configuration from the stored set of pre-modeled chiller system configurations.

In embodiments, given a chiller system 200 of **n** chiller devices 102a-102n, each chiller device having known properties and settings (active/inactive, $T_{setpoint}$, $\dot{m}_{setpoint}$), a current state of an environment (e.g., plant 106 of FIG. 2; environmental conditions 304-308) including a required cooling load 312, a determination of an optimal chiller system configuration to maintain the required cooling load while minimizing total energy consumption 314 may account for the number and properties of the **n** chiller devices 102a-102n as well as the need to maintain the required cooling load without interruption. Accordingly, any chiller system configurations disruptive to the required cooling load 312 (e.g., as a result of executing one or more actions to achieve said configuration) may be discarded. Further, any viable chiller system configuration solutions may need to account for other physical limitations or rules. For example, one approach to optimization may require the number **m** of active chiller devices 102a-102m (e.g., where **m** ≤ **n,** the total number of chiller devices 102a-102n) to remain constant, thus proscribing the activation of inactive chiller devices or the deactivation of active chiller devices, while another approach to optimization may provide for the activation or deactivation of individual chiller devices as viable actions.

Further still, while the purpose of the underlying objective function may be to minimize total energy consumption 314 of the chiller system 200, any solutions to the objective function may be required to account for other parameters such as: operational ranges (e.g., minimum/maximum inlet temperatures and flow rates); minimum/maximum cooling capacity of any individual chiller device 102a-102n; or allowable error (e.g., chiller system configurations may be accepted as possible solutions if they maintain required cooling load 312 within an allowable margin for error, e.g., 1%). As noted above, offline and online implementations of optimization management by the supervisory control device 202 may trade flexibility for computational demand. For example, online optimization may require significantly higher computational demand but may allow for chiller system customization, e.g., addition of new chiller devices 102a-102n or modification of operating ranges. For example, when initial tuning and device population of a chiller system 200 is completed, evaluating the optimal chiller configuration may be solvable by retrieving from the memory 206 the optimal precomputed solution configuration having the lowest associated energy consumption level 314.

In embodiments, the supervisory control device 202 may attempt to build and/or determine one or more possible optimization solutions given a chiller system 200 of chiller devices 102a-102n, each chiller device associated with specific physical properties and settings (e.g., a range of possible outlet fluid temperature setpoints $T_{setpoint}$, a range of possible outlet flow rate setpoints $\dot{m}_{setpoint}$) and corresponding to a mathematical chiller model 300. For example, a possible optimization solution may include any configuration of the chiller system 200, e.g., any set of possible ($T_{setpoint}$, $\dot{m}_{setpoint}$) for each chiller device 102a-102n and a current set of environmental conditions 304-312 within the plant 106, where a required cooling load 312 is maintained on an uninterrupted basis and the total energy consumption 314 is less than the current energy consumption based on the current configuration of the chiller system. It may be noted that for a given chiller system 200 in a current configuration and a plant 106 in a given environmental state, the number of possible optimizing solutions may be zero, one, or more than one; in the latter case, the optimal solution may be the solution providing for the greatest reduction in energy consumption 314. In some embodiments, an optimization solution may be acceptable if the reduction in energy consumption 314 is within an acceptable range of the delta threshold, e.g., 1%.

In embodiments, optimizing solutions may be defined in two basic ways. For example, the first type of optimizing solution may provide that the number Z of active chiller devices 102a-102n (e.g., where Z ≤ N) must remain constant, with no chiller devices activated or deactivated and any modifications in the chiller system configuration based solely on adjustments to the outlet fluid temperature setpoint $T_{setpoint}$ and/or outlet flow rate setpoint $\dot{m}_{setpoint}$ of one or more chiller devices. The second type of optimizing solution may additionally allow activation or deactivation of chiller devices 102a-102n if a greater reduction in total energy consumption 314 may be achieved.

In embodiments, assuming a quality mathematical model 300 for each chiller device 102a-102n of the chiller system 100 (e.g., a model for the chiller system 200 as a whole, or a set of models for each component chiller device 102a-102n), each model may take as an input a flow rate $Q_s$ (310, m$^3$/h), a supply fluid temperature $T_s$ (306, °C), an ambient temperature $T_{ambient}$ (302, °C), an outlet fluid temperature $T_{outlet}$ (308, °C), and a required cooling capacity $Req_{load}$ (312, kW). By way of a non-limiting example, the first type of optimizing solution may be achieved according to the formulation below:

$$min_{Qs_i,Ts_i} \sum_{i=1}^{n} M\_energy_i(x,p)$$

$$s.t.: \frac{(abs(Req_{load}) - \sum_{i=1}^{m} M\_capacity_i(x,p))}{Req_{load}} \leq z\%$$

$$Qs_{i_{min}} \leq Qs_i \leq Qs_{i_{max}}$$

$$Ts_{i_{min}} \leq Ts_i \leq Ts_{i_{max}}$$

$$capacity_{i_{min}} \leq M\_capacity_i(x,p) \leq capacity_{i_{max}}$$

$$\forall i \in \{1,...,n\}$$

$$x = \begin{pmatrix} Qs_i \\ Ts_i \end{pmatrix}$$

$$p = \begin{pmatrix} T_{Ambient} \\ T_{outlet} \\ Req_{load} \end{pmatrix}$$

where the result of the optimization solution includes an outlet fluid temperature setpoint $T_{setpoint}$ and/or an outlet flow rate setpoint $\dot{m}_{setpoint}$ for one or more chiller devices 102a-102n of the chiller system 200.

Similarly, by way of a non-limiting example, the second type of optimization solution, where activation or deactivation of chiller devices 102a-102n of the chiller system 200 is allowed, may be achieved via the following formulation:

$$min_{Qs_i, Ts_i, A_i} \sum_{i=1}^{n} M\_energy_i(x, p) * A_i$$

$$s.t.: \frac{(abs(Req_{load}) - \sum_{i=1}^{m} M\_capacity_i(x, p))}{Req_{load}} \leq z\%$$

$$Qs_{i_{min}} \leq Qs_i \leq Qs_{i_{max}}$$

$$Ts_{i_{min}} \leq Ts_i \leq Ts_{i_{max}}$$

$$capacity_{i_{min}} \leq M\_capacity_i(x, p) \leq capacity_{i_{max}}$$

$$\forall i \in \{1, \dots, n\}$$

$$x = \begin{pmatrix} Qs_i \\ Ts_i \end{pmatrix}$$

$$p = \begin{pmatrix} T_{Ambient} \\ T_{outlet} \\ Req_{load} \end{pmatrix}$$

$$A_i \in \{0,1\}$$

where, for example, $A_i$ refers to the active/inactive state (e.g., 0 = inactive, 1 = active) of a given chiller device $1 \leq i \leq n$ of the chiller system 200 having $n$ chiller devices. Thus, this second type of optimization solution may additionally output a list of active chiller devices $i$ selected from the full set of $n$ chiller devices 102a - 102n, where each active chiller device $i$ represents a chiller device that is either already active (e.g., at a particular flow rate setpoint and outlet temperature setpoint) or that must be activated.

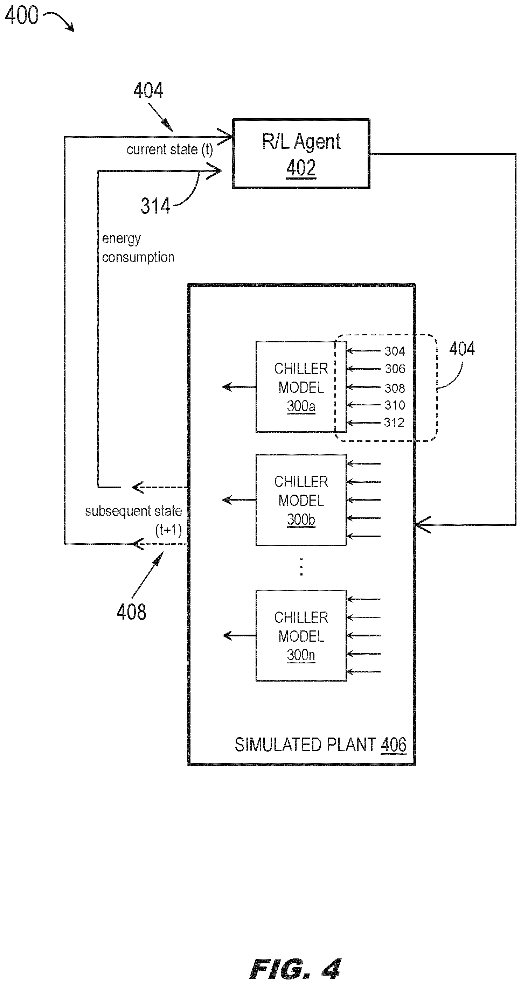

In embodiments, referring to FIG. 4, the simulated chiller system 400 may be implemented and may function similarly to the chiller systems 100, 100a, 200 of FIGS. 1A, 1B, and 2, except that the simulated chiller system 400 may incorporate modeling of possible chiller system configurations, determining the total energy consumption level 314 associated with each chiller system configuration as discussed above (e.g., offline modeling and storage of possible chiller system configurations), and formulation of an optimizing solution. For example, an optimizing solution may include a sequence of actions for converting the chiller system 200 (see FIG. 2) as currently configured, e.g., based on the active/inactive, flow rate setpoint, and outlet temperature setpoint of each chiller device 102a - 102n (see FIG. 2), to an optimal chiller system configuration, e.g., wherein the total energy consumption 314 of the chiller system is minimized, via trained reinforcement learning (RL) agents 402.

In embodiments, an RL agent 402 may map a current state 404 of the plant 106 (e.g., ambient air temperature 304, inlet fluid temperature 306, outlet fluid temperature 308, entering fluid flow rate 310, requested cooling load 312, as shown by FIG. 3) to possible actions applicable to the current state to minimize one or more cost functions (e.g., electrical power consumption level 314). For example, the component actions of the optimizing solution, and of any other candidate solution, may include:

- adjusting (e.g., raising or lowering) the outlet fluid temperature setpoint $T_{setpoint}$ for an active chiller device 102a-102n;

- adjusting the flow rate setpoint $\dot{m}_{setpoint}$ for an active chiller device;

- activating a currently inactive chiller device (if permitted by the control scheme); or

- deactivating a currently active chiller device (if permitted by the control scheme).

In embodiments, the RL agent 402 may be trained on a simulated plant 406 environment corresponding to the plant 106 (see FIG. 2) of the chiller system 200. For example, given any possible current state 404 of the plant 106 (including the corresponding current configuration of the component chiller devices 102a - 102n of the chiller system 200), the RL agent 402 may be trained to learn the best action possible at that state to minimize total energy consumption 314 while maintaining the required cooling load 312. In embodiments, development of the RL agent 402 may begin with data acquisition (e.g., chiller modeling via rating software during steady state operations of the chiller system 200) followed by training of neural networks 302 (see FIG. 3) within each chiller model 300a-300n (see FIG. 3) corresponding to a chiller device 102a-102n of the chiller system. Development may continue with training of the RL agent 402, and ultimately implementation of the trained RL agent. One advantage of this approach is that an optimizing solution may be determined independently of the actual environmental conditions of the plant 106 and/or chiller system 200, as the simulated chiller system 400 is capable of reproducing the full range of possible environmental conditions 304-312 (see FIG. 3).

In embodiments, the neural network/s 302 representing the trained RL agent 402 may be implemented via the supervisory control device 202 (see FIG. 2) to provide real-time direct control of the chiller system 200 and its component chiller devices 102a-102n. For example, the uploaded neural network/s 302 may map real-time operational parameters (e.g., conditions within the plant 106, configurations of each chiller device 102a-102n) to determine the optimal chiller system configuration and implement any actions necessary to achieve the optimal chiller system configuration from the current chiller system configuration. Conditions within the plant 106 may include a current state 404 of the plant (e.g., at a time $t$) and a subsequent state 408 of the plant (e.g., at a time $t+1$) indicative of changing environmental conditions within the plant due to the implemented actions.

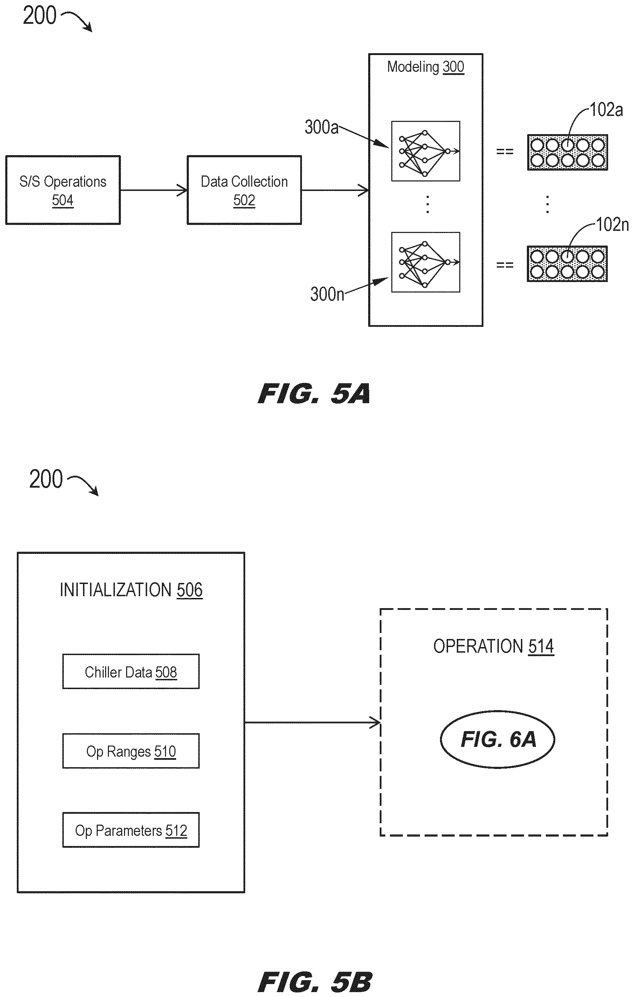

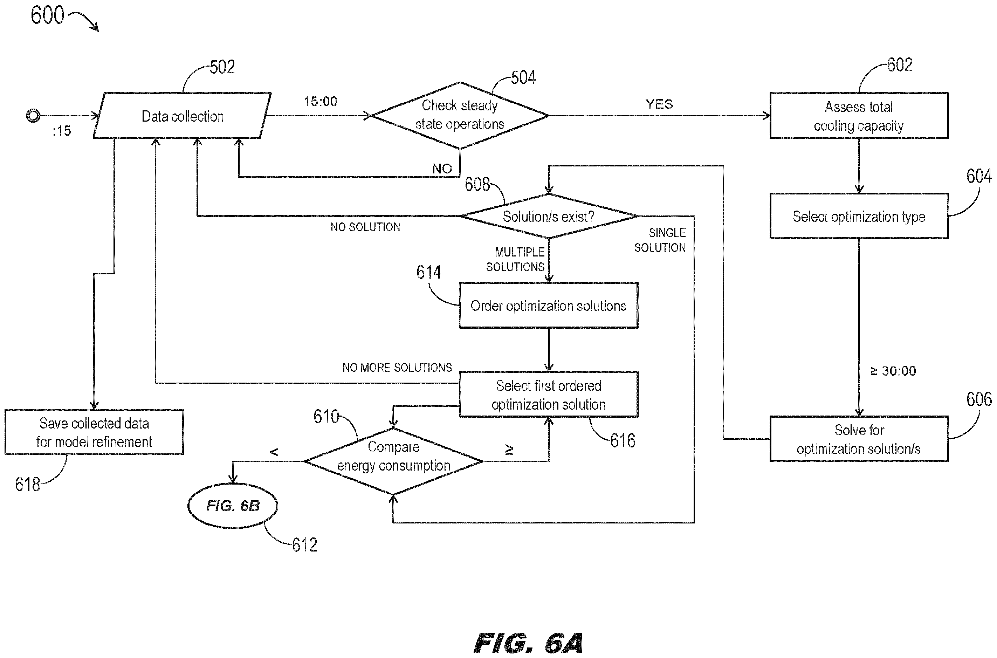

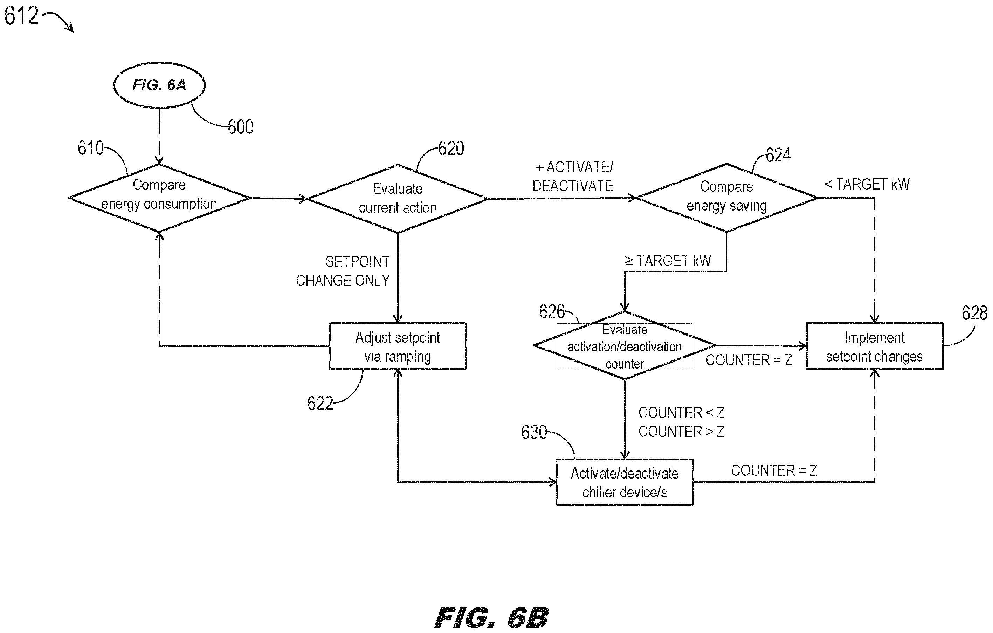

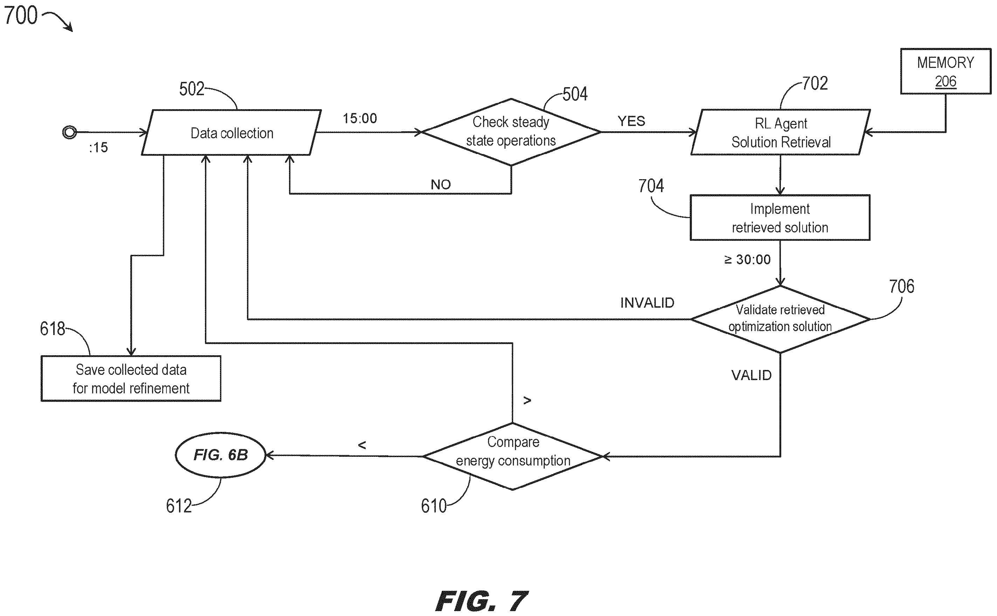

Referring generally to FIGS. 5A through 7, example architectures for optimization management may provide for offline data collection and modeling of possible configurations of the chiller system 200 (e.g., as shown by FIG. 5A), online initialization and operation of the chiller system 200 (e.g., as shown by FIG. 5B), supervised evaluation of feasible solutions from a given current state 404 (see FIG. 4) of the plant 106 (see FIG. 6A), implementation of actions or changes associated with a possible solution by ramping a particular chiller device 102a-102n (see FIG. 6B), and/or offline precomputation and preevaluation of possible solutions including an optimizing solution (e.g., as shown by FIG. 7).

Referring in particular to FIG. 5A, the chiller system 200 is shown.

In embodiments, offline data collection 502 may allow the supervisory control device 202 (see FIG. 2) to maintain the chiller system 200 in steady state operations 504, e.g., for at least a threshold duration, so that information about chiller device setpoints (e.g., inlet temperature, flow rate) may be observed, e.g., via rating software. For example, steady-state data may allow for modeling 300 of the chiller system 200, as shown above by FIGS. 3 and 4, such that a chiller model 300a-300n corresponds to each chiller device 102a-102n.

Referring also to FIG. 5B, the chiller system 200 is shown.

In embodiments, the individual chiller devices 102a - 102n (see FIG. 2) of the chiller system 200 and the plant 106 (see FIG. 2) may be initialized 506 according to any necessary properties such as chiller data 508 (e.g., the number and type of chiller devices 102a-102n), operating ranges 510 for each chiller device, and/or operational parameters 512 (e.g., how often setpoint changes are allowed, whether chiller device activation and deactivation are allowed). For example, once the chiller system 200 is initialized 506 and operational 514 (as shown in greater detail by FIG. 6A), the collection of operating data 502, which may include the measurement or collection of, e.g., flow rate and outlet temperature setpoints for each chiller device 102a-102n, environmental conditions 304-312 (see FIG. 3) within the plant 106, and/or other inputs to an optimizing solution) may continue (e.g., at a predetermined frequency, such as every 10 or 15 seconds). In embodiments, collected datasets may be stored and/or saved for evaluation and/or retraining of RL agents 402 (see FIG. 4).

In embodiments, referring back to FIG. 5A, collection of operating data 502 may ensure that the chiller system 200 is operating at a steady state 504 for a sufficient duration (e.g., 15 minutes) to allow optimization to proceed. For example, steady state operations 504 may be defined as a duration wherein no chiller devices 102a-102n are activated or deactivated, and wherein total inlet temperature $T_{inlet}$ and flow rate $\dot{m}$ into the plant 106 (see FIG. 1; e.g., via the input conduit 104) do not oscillate beyond predetermined thresholds.

Referring now to FIG. 6A, an optimization process 600 of the initialized and operational chiller system 200 (see FIG. 2) is shown.

In embodiments, once data collection 502 verifies that steady state operations 504 of the chiller system 200 have been established for at least a threshold duration (e.g., 15 minutes), the supervisory control device 202 (see FIG. 2) may assess the total cooling capacity (602) delivered by the chiller system 200 under its current configuration. For example,

**EP 4 567 532 A1**

based on the desired type of optimization solution selected (604; e.g., a less conservative approach (second type) allowing chiller device activation/deactivation, or a more conservative approach (first type) proscribing activation/deactivation) the supervisory control device 202 may attempt to solve (606) for one or more optimization solutions. In some embodiments, to prevent unwanted oscillation within the chiller system 200 (e.g., due to frequent setpoint changes), the timing or frequency of intrusion into the chiller system to solve for (606) and/or implement an optimization solution may be limited (e.g., no more frequently than every 30 minutes).

In embodiments, based on data collection 502 and the determined current cooling capacity (602) of the chiller system 200 under its current configuration, the supervisory control device 202 may determine (608) that either one or more optimization solutions may exist or that no solution may exist. For example, if no optimization solution is found, data collection 502 may resume, and steady state operations 504 may be maintained, until a subsequent attempt to solve 606 (e.g., after confirming via data collection a sufficient duration of steady state operations and after again determining total cooling capacity 602). In embodiments, if a single optimization solution is found, the supervisory control device 202 may determine (610) whether total energy consumption 314 (see FIG. 3) associated with the optimization solution (e.g., with the chiller system configuration proposed by the optimization solution) are sufficiently lower than energy consumption levels associated with the current configuration of the chiller system 200. For example, if the delta between proposed and current energy consumption, or the amount of energy conserved by implementing the proposed optimization solution, meets or exceeds a threshold level, the proposed solution (or, e.g., the next action or sequence of actions of the proposed solution). may be evaluated for implementation (612; as shown by FIG. 6B) by the supervisory control device 202.

In embodiments, if multiple optimization solutions are found, the supervisory control device 202 may test each solution, rank or order (614) the optimization solutions in order of greatest reduced energy consumption, and select as the optimizing solution, e.g., for comparison of energy consumption 610, the first ordered optimization solution (616. If, for example, the first ordered optimization solution sufficiently reduces energy consumption, e.g., to at least a threshold level, the first ordered solution may be evaluated for implementation 612. Further, the supervisory control device 202 may evaluate in order any remaining optimization solutions, e.g., if the first ordered solution is not implemented. For example, if activation or deactivation of chiller system devices 102a-102n is allowed in furtherance of a first ordered optimization solution, the required energy saving threshold may be higher than if activation or deactivation was not allowed. However, if an optimization type was selected (604) specifically proscribing activation or deactivation of chiller devices 102a - 102n, the first ordered solution may be discarded in favor of an optimization solution that achieves at least a threshold reduction in energy consumption without the activation or deactivation of chiller devices.

In embodiments, the supervisory control device 202 may save (618) any collected datasets, e.g., to memory 206 (see FIG. 2), for evaluation and/or further refinement of chiller system models 300 (see FIG. 3) and/or RL agent 402 (see FIG. 4).

Referring also to FIG. 6B, an evaluation process 612 of a proposed optimization solution by the supervisory control device 202 (see FIG. 2) is shown.

In embodiments, an evaluation 612 of a proposed optimization solution incorporating adjustments of inlet temperature or flow rate setpoints of one or more component chiller devices 102a-102n of the chiller system 100 may include an evaluation 618 of each action or step of the proposed optimization solution. For example, if the proposed optimization solution includes only changes to inlet temperature and/or flow rate setpoints, e.g., as opposed to activation or deactivation of chiller devices 102a-102n, implementation may be achieved via gradual ramping 620 of each current device setpoint (e.g., inlet temperature and/or flow rate) to the corresponding solution setpoint, to reduce stress on the chiller system 200 and its component chiller devices. Further, referring back to FIG. 6A, once the solution setpoint/s have been achieved, and once steady state operations 504 for a sufficient duration have been confirmed via data collection 502, total cooling capacity under the solution conditions may be evaluated (602) and the overall effect of the proposed solution on energy consumption assessed (610) relative to the appropriate delta threshold.

In some embodiments, where a proposed optimization solution includes activation and/or deactivation of chiller system devices 102a-102n, the delta threshold for reduced energy consumption, e.g., wherein the supervisory control device 202 compares (624) energy consumption under the proposed solution with current energy consumption, may be higher than the delta threshold where only setpoint changes are required. For example, the higher delta threshold may account for increased stress on the chiller system 200 and its component chiller devices 102a-102n associated with activation/deactivation of chiller devices, and may therefore require a more significant reduction in energy consumption to justify the additional stress.

In embodiments, when, the reduction in energy consumption associated with the second-type optimization solution meets or exceeds the higher delta threshold (e.g., in kW), activation or deactivation of chiller devices 102a - 102n may be executed first. For example, the supervisory control device 202 may first evaluate (606) the current number of active chiller devices i within the set of n chiller devices 102a - 102n. If the number of currently active chiller devices 102a - 102n is equal to the target number Z of active chiller devices proposed by the optimization solution, the supervisory control device 202 may proceed to implement any setpoint changes (628) proposed by the optimization solution, e.g., via ramping (620) of flow rate and outlet temperature setpoints to the proposed targets.

In embodiments, if the current number of active chiller devices i is either less or greater than the target number Z of active chiller devices proposed by the optimization solution, the supervisory control device 202 may first activate and/or deactivate chiller devices (630) until the target number Z of active chiller devices is reached.

In some embodiments, computation and evaluation of optimizing solutions may be performed offline rather than online (e.g., as shown above in FIGS. 6A and 6B). For example, referring to FIG. 7, an optimization process 700 for implementation by an RL agent 402 (see FIG. 4) of optimizing solutions evaluated and stored offline by the supervisory control device 202 9see FIG. 2) is shown.

In embodiments, the optimization process 700 may provide for the advance offline evaluation (e.g., as shown by FIG. 6B) and storage, e.g., to memory 206 (see FIG. 2), of all possible optimizing solutions. For example, the optimization process 700 may first assume a current state 404 (see FIG. 4; comprising environmental conditions 304-312) within the plant 106 (see FIG. 4), and may perform data collection 502 to verify (504) steady state operations of the chiller system 200 (see FIG. 2) for at least a threshold duration. In embodiments, collected datasets may be saved (618) for model refinement.

In embodiments the RL agent 402, rather than solving online (606, FIG. 6A) for one or many possible optimizing solutions, may instead look up or retrieve (702) from memory 206 the optimizing solution corresponding to, or most closely matching, the current state 404 within the plant 106. For example, once the corresponding optimizing solution is retrieved (702) by the RL agent 402 and implemented (704) by the supervisory control device 202, a safety check of the optimizing solution may be introduced (706) to validate that the real-world effects and consequences of the proposed optimizing solution match its effects as previously computed offline. For example, a retrieved RL optimization solution may first be observed for a minimum duration (e.g., 30 minutes) to ensure that the result determined offline and retrieved by the RL agent 402 corresponds to the actual result of the proposed actions (e.g., sufficiently reduced energy consumption as opposed to the current configuration) when implemented by the chiller system 200. If this check fails, for example, the supervisory control device 202 may return to data collection 502 to verify 504 steady state operations of the chiller system 200. In embodiments, the RL agent 402 may be directed to retrieve (702) a subsequent optimization solution once steady state operations are resumed and verified. Further, invalid optimization solutions may lead to further refinement of chiller system models 300 (see FIG. 3). In embodiments, when a retrieved RL optimization solutions is checked 706 and validated to perform in alignment with the previously determined offline results, the valid retrieved RL optimization solution may be assessed 610, e.g., as described above with respect to online optimization process 600 of FIG. 6A, to determine if the optimization solution sufficiently reduces energy consumption to allow implementation 612 of the optimization solution, as shown by FIG. 6B.

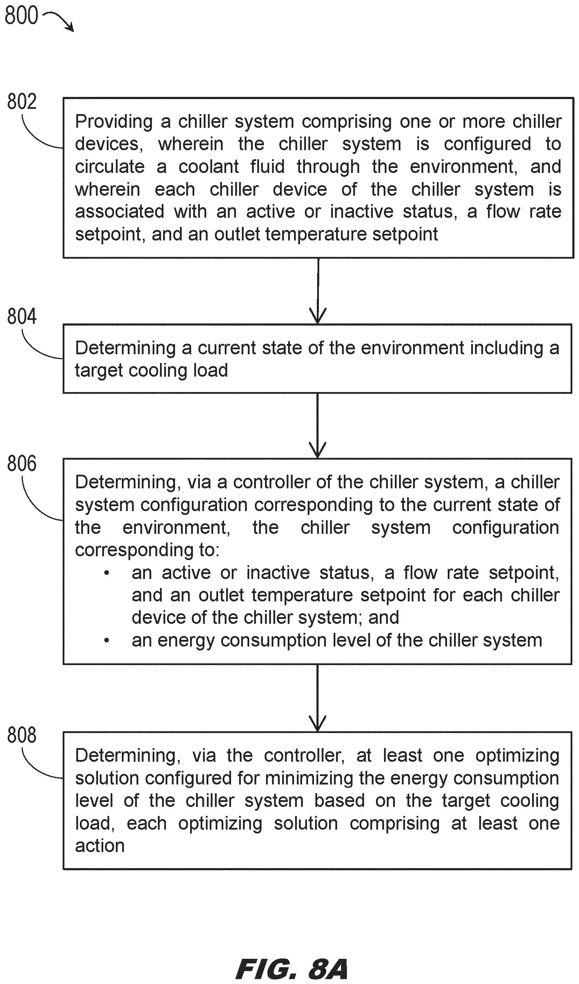

Referring now to FIG. 8A, a method 800 for optimizing management of a chiller system to minimize total energy consumption while maintaining a desired cooling capacity for a plant or other target environment may include the following steps.

Step 802 includes providing a chiller system of n chiller devices, where each chiller device has an active or inactive status, a coolant fluid flow rate setpoint, and an inlet medium temperature setpoint.

Step 804 includes determining (e.g., via a supervisory controller device of the chiller system) a current state within the plant or target environment. For example, the current state includes the ambient air temperature proximate to or within the plant, the inlet temperature of chilled coolant fluid entering the plant and the outlet temperature of warmer coolant fluid returning to the chiller system from the plant, a flow rate of the coolant fluid into the plant, and a target cooling load (e.g., desired cooling capacity) to be maintained within the plant.

Step 806 includes determining a current configuration of the chiller system based on the current state of the plant. For example, the current configuration may provide for a number of active chiller devices as well as a current flow rate setpoint and temperature setpoint for each active chiller device. Further, based on the number of active chiller devices and their respective setpoints, step 806 includes determining the current total energy consumption level of the chiller system.

Step 808 includes determining an optimizing solution whereby the target cooling load for the plant may be maintained uninterrupted, but the energy consumption level may be minimized. For example, an optimizing solution may involve adjusting the inlet temperature and/or flow rate setpoints for one or more active chiller devices. In some embodiments, optimizing solutions may further include the activation of inactive chiller devices or the deactivation of active chiller devices.

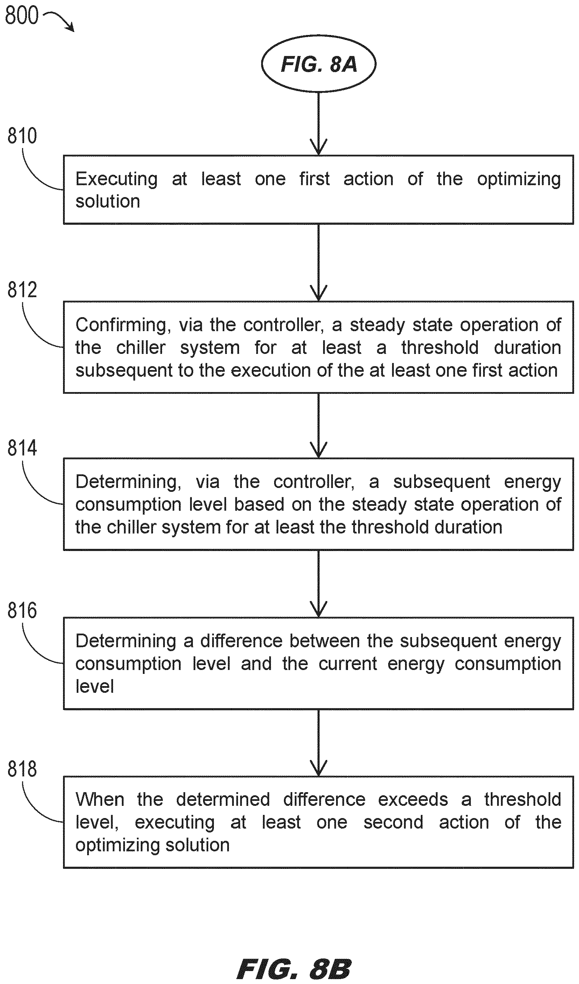

Referring also to FIG. 8B, the method 800 may include additional steps 810 through 818.

Step 810 includes executing a first action of the determined optimizing solution. For example, the first action may be an activation or deactivation of a chiller device, if allowed by the supervisory control device. Alternatively, or additionally, the first action may be an adjustment of a flow rate setpoint or outlet temperature setpoint of an active chiller device of the chiller system.

Step 812 includes confirming steady state operation of the chiller system, e.g., via collection of data from the chiller devices and/or from within the plant, for at least a threshold duration after execution of the first action.

Step 814 includes determining, based on the subsequent steady state operation of the chiller system for at least the threshold duration, energy consumption associated with the chiller system (e.g., whether, and to what extent, the execution of the first action reduced total energy consumption).

Step 816 includes determining a delta or difference between the subsequent energy consumption and the total energy consumption of the chiller system under its current configuration (e.g., prior to execution of the first action/implementation of the optimization solution).

Step 818 includes, when the delta or difference meets or exceeds a threshold level, executing a subsequent action of the implementation solution. For example, when a second-type optimization solution provides for the activation or deactivation of chiller devices, the threshold for reduced energy consumption may be higher than for a first-type optimization solution that proscribes activation or deactivation. A higher threshold requirement for second-type optimization solution justifies the additional stress placed on the chiller devices due to activation and/or deactivation.

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java®, Fortran, Peri, Pascal, Curl, OCaml, Javascript®, HTML5 (Hypertext Markup Language 5th revision), Ada, ASP (Active Server Pages), PHP (PHP: Hypertext Preprocessor), Scala, Eiffel, Smalltalk, Erlang, Ruby, Flash®, Visual Basic®, Lua, MATLAB, SIMULINK, and Python®.

Process flowcharts discussed herein illustrate the operation of possible implementations of systems, methods, and computer program products according to various embodiments of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

**Claims**

1.    An optimizing chiller system, comprising:
one or more chiller devices fluidly coupled to an environment, the one or more chiller devices collectively configured to circulate a coolant fluid through the environment; and
a controller operatively coupled to each of the one or more chiller devices, the controller comprising at least one processor and configured to:

determine a current state of the environment including a target cooling load;
determine a chiller system configuration corresponding to the current state of the environment, the chiller system configuration corresponding to:

an active or inactive status, a flow rate setpoint, and an outlet temperature setpoint for each chiller device of the chiller system; and
an energy consumption level of the chiller system; and

determine at least one optimizing solution configured for minimizing the energy consumption level of the chiller system based on the target cooling load associated with the current state of the environment, each optimizing solution comprising at least one action.

2. The chiller system of claim 1, wherein the at least one action comprises at least one of:

changing at least one flow rate setpoint of an active chiller device of the chiller system, or
changing at least one outlet temperature setpoint of an active chiller device of the chiller system, and optionally

wherein the at least one action further comprises at least one of:

activating at least one inactive chiller device of the chiller system, or
deactivating at least one active chiller device of the chiller system.

3. The chiller system of claim 2, wherein the controller is configured to change the flow rate setpoint of the active chiller device by ramping the current flow rate setpoint of the active chiller device to a target flow rate setpoint, and/or wherein the controller is configured to change the outlet temperature setpoint of the active chiller device by ramping the current outlet temperature setpoint to a target outlet temperature setpoint.

4. The chiller system of any preceding claim, wherein the controller is configured to model a plurality of possible chiller system configurations of the chiller system, and
wherein each possible chiller system configuration corresponds to an active or inactive status, a flow rate setpoint, and an outlet temperature setpoint for each chiller device of the chiller system.

5. The chiller system of claim 4, further comprising:

a memory coupled to the at least one processor, the memory configured for storage of the plurality of possible chiller system configurations;
wherein the controller is configured to determine the at least one optimizing solution by selecting a target chiller system configuration from the stored plurality of possible chiller system configurations, based on the target cooling load associated with the current state of the environment.

6. The chiller system of claim 4 or 5, wherein the controller is configured to model the plurality of possible chiller system configurations via at least one regression-based neural network.

7. The chiller system of any preceding claim, wherein the controller is further configured to:

execute at least one first action of the optimizing solution,
confirm a steady state operation of the chiller system for at least a threshold duration subsequent to the at least one executed first action;
determine, via the controller, a subsequent energy consumption level of the chiller system, the subsequent energy consumption level based on the steady state operation of the chiller system for at least the threshold duration,
determine a difference between the subsequent energy consumption level and the current energy consumption level, and
when the determined difference exceeds a threshold level, execute at least one second action of the optimizing solution.

8. The chiller system of any preceding claim, wherein the current state of the environment comprises:

an ambient air temperature;
an inlet temperature of the coolant fluid entering the environment;
an inlet flow rate of the coolant entering into the environment; and
an outlet temperature of the coolant fluid leaving the environment.

9. A method for optimizing management of a chiller system, the method comprising:

providing a chiller system comprising one or more chiller devices, wherein the chiller system is configured to circulate a coolant fluid through an environment, and wherein each chiller device of the chiller system is associated with an active or inactive status, a flow rate setpoint, and an outlet temperature setpoint;

determining a current state of the environment including a target cooling load;

determining, via a controller of the chiller system, a chiller system configuration corresponding to the current state of the environment, the chiller system configuration corresponding to:

an active or inactive status, a flow rate setpoint, and an outlet temperature setpoint for each chiller device of the chiller system; and

an energy consumption level of the chiller system;

associated with an energy consumption level of the chiller system; and

determining, via the controller, at least one optimizing solution configured for minimizing the energy consumption level of the chiller system based on the target cooling load, each optimizing solution comprising at least one action.

10. The method of claim 9, wherein the at least one action includes at least one of:

changing a flow rate setpoint of at least one active chiller device of the chiller system;
or

changing an outlet temperature setpoint of at least one active chiller device of the chiller system, and optionally

wherein the at least one action further comprises at least one of:

activating at least one inactive chiller device of the chiller system; or
deactivating at least one active chiller device of the chiller system.

11. The method of claim 10, wherein changing the flow rate setpoint of an active chiller device of the chiller system includes ramping the current flow rate setpoint of the active chiller device to a target flow rate setpoint, and/or wherein changing the outlet temperature setpoint of an active chiller device of the chiller system includes ramping the current outlet temperature setpoint to a target outlet temperature setpoint.

12. The method of any of claims 9 to 11, wherein determining, via the controller, a current state of the environment includes:

modeling a plurality of possible chiller system configurations of the chiller system, wherein each possible chiller system configuration corresponds to an active or inactive status, a flow rate setpoint, and an outlet temperature setpoint for each chiller device of the chiller system; and

storing the plurality of possible chiller system configurations to a memory of the controller.

13. The method of claim 12, wherein determining, via the controller, at least one optimizing solution configured for minimizing the energy consumption level of the chiller system includes selecting a target chiller system configuration from the plurality of possible chiller system configurations based on the target cooling load, and/or wherein determining, via the controller, a current chiller system configuration corresponding to the current state of the environment includes modeling the plurality of possible chiller system configurations based on the current state of the environment via at least one regression-based neural network.

14. The method of any of claims 9 to 13, further comprising:

executing at least one first action of the optimizing solution;
confirming, via the controller, a steady state operation of the chiller system for at least a threshold duration subsequent to the execution of the at least one first action;
determining, via the controller, a subsequent energy consumption level based on the steady state operation of the chiller system for at least the threshold duration;
determining a difference between the subsequent energy consumption level and the current energy consumption level; and
when the determined difference exceeds a threshold level, executing at least one second action of the optimizing solution.

15. The method of any of claims 9 to 14, wherein determining a current state environment includes determining:

an ambient air temperature,
an inlet temperature of the coolant fluid entering the environment,
an inlet flow rate of the coolant fluid entering the environment, and
an outlet temperature of the coolant fluid leaving the environment.

**FIG. 1A**

**FIG. 1B**

FIG. 2

**FIG. 3**

400

404

current state (t)

R/L Agent
402

314

energy
consumption

subsequent state
(t+1)

408

CHILLER
MODEL
300a

— 304
— 306
— 308
— 310
— 312

404

CHILLER
MODEL
300b

CHILLER
MODEL
300n

SIMULATED PLANT 406

*FIG. 4*

200

Modeling 300

300a

300n

S/S Operations 504 → Data Collection 502

102a

102n

**FIG. 5A**

200

INITIALIZATION 506

Chiller Data 508

Op Ranges 510

Op Parameters 512

OPERATION 514

FIG. 6A

**FIG. 5B**

**FIG. 6A**

FIG. 6B

700

MEMORY 206

702 — RL Agent Solution Retrieval

704 — Implement retrieved solution

≥ 30:00

706 — Validate retrieved optimization solution

VALID

INVALID

504 — Check steady state operations

YES

NO

15:00

502 — Data collection

:15

618 — Save collected data for model refinement

610 — Compare energy consumption

>

<

612 — FIG. 6B

**FIG. 7**

800 ⟍

802
Providing a chiller system comprising one or more chiller devices, wherein the chiller system is configured to circulate a coolant fluid through the environment, and wherein each chiller device of the chiller system is associated with an active or inactive status, a flow rate setpoint, and an outlet temperature setpoint

804
Determining a current state of the environment including a target cooling load

806
Determining, via a controller of the chiller system, a chiller system configuration corresponding to the current state of the environment, the chiller system configuration corresponding to:
- an active or inactive status, a flow rate setpoint, and an outlet temperature setpoint for each chiller device of the chiller system; and
- an energy consumption level of the chiller system

808
Determining, via the controller, at least one optimizing solution configured for minimizing the energy consumption level of the chiller system based on the target cooling load, each optimizing solution comprising at least one action

## FIG. 8A

800

FIG. 8A

810
Executing at least one first action of the optimizing solution

812
Confirming, via the controller, a steady state operation of the chiller system for at least a threshold duration subsequent to the execution of the at least one first action

814
Determining, via the controller, a subsequent energy consumption level based on the steady state operation of the chiller system for at least the threshold duration

816
Determining a difference between the subsequent energy consumption level and the current energy consumption level

818
When the determined difference exceeds a threshold level, executing at least one second action of the optimizing solution

FIG. 8B

EP 4 567 532 A1

## EUROPEAN SEARCH REPORT

Application Number

EP 24 21 3180

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/034024 A1 (PATEL NISHITH R [US] ET AL) 4 February 2021 (2021-02-04)<br>* figure 6 *<br>* paragraph [0116] *<br>* paragraph [0174] - paragraph [0176] *<br>* paragraph [0188] *<br>* paragraph [0168] *<br>* paragraph [0201] *<br>* paragraph [0206] *<br>* paragraph [0124] - paragraph [0125] *<br>* paragraph [0340] *<br>* paragraph [0376] *<br>----- | 1-15 | INV.<br>G05B13/04<br>F24F11/46<br>G05B17/02 |
| X<br>A | US 2015/192317 A1 (ASMUS MATTHEW J [US]) 9 July 2015 (2015-07-09)<br>* figures 1,3A *<br>* paragraph [0018] - paragraph [0019] *<br>* paragraph [0091] *<br>* paragraph [0053] *<br>* paragraph [0061] - paragraph [0062] *<br>----- | 1,9<br><br>2-8,<br>10-15 | |

TECHNICAL FIELDS SEARCHED (IPC)

G05B
F24F

The present search report has been drawn up for all claims

| Place of search | Date of completion of the search | Examiner |
|---|---|---|
| The Hague | 29 April 2025 | Antonopoulos, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

26

## ANNEX TO THE EUROPEAN SEARCH REPORT
## ON EUROPEAN PATENT APPLICATION NO.

EP 24 21 3180

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2025

| Patent document cited in search report | Publication date | Patent family member(s) | Publication date |
|---|---|---|---|
| US 2021034024 A1 | 04-02-2021 | NONE | |
| US 2015192317 A1 | 09-07-2015 | US 2013345880 A1<br>US 2015192317 A1 | 26-12-2013<br>09-07-2015 |

For more details about this annex : see Official Journal of the European Patent Office, No. 12/82

**REFERENCES CITED IN THE DESCRIPTION**

**Patent documents cited in the description**

- US 63603476